# FASCICULE DE BREVET EUROPEEN

(11) **EP 2 143 687 B1**
(45) Date de publication et mention de la délivrance du brevet: **07.12.2016**
(21) Numéro de dépôt: 09290535.5
(22) Date de dépôt: 03.07.2009
(51) Int. Cl.: C01B 33/037, H01L 21/322, H01L 31/0236, H01L 31/028, H01L 31/18

(54) **PROCÉDÉ DE PURIFICATION D'UN SUBSTRAT EN SILICIUM CRISTALLIN ET PROCÉDÉ D'ÉLABORATION D'UNE CELLULE PHOTOVOLTAÏQUE**
REINIGUNGSVERFAHREN EINES SUBSTRATS AUS KRISTALLINEM SILIZIUM UND HERSTELLUNGSVERFAHREN EINER FOTOVOLTAIKZELLE
METHOD FOR PURIFYING A SUBSTRATE IN CRYSTALLINE SILICON AND METHOD FOR MANUFACTURING A PHOTOVOLTAIC CELL

(30) Priorité: 09.07.2008 FR 0803904
(43) Date de publication de la demande: 13.01.2010
(73) Titulaire: Commissariat à l'Énergie Atomique et aux Énergies Alternatives, 75015 Paris (FR)
(72) Inventeur: Dubois, Sébastien, 74950 Scionzier (FR); Enjalbert, Nicholas, 81100 Burlats (FR); Monna, Rémi, 68640 Muespach le Haut (FR)
(74) Mandataire: Gevers & Orès

(56) Documents cités:
- RUBY D S ET AL: "The effects of different diffusion sources on silicon solar cell recombination properties", CONFERENCE RECORD OF THE TWENTY FIRST IEEE PHOTOVOLTAIC SPECIALISTS CONFERENCE, 1990, 21 mai 1990 (1990-05-21), pages 311-316, XP010003198,
- GEE J M ED - INSTITUTE OF ELECTRICAL AND ELECTRONICS ENGINEERS: "Phosphorous diffusions for gettering-induced improvement of lifetime in various silicon materials", PROCEEDINGS OF THE PHOTOVOLTAIC SPECIALISTS CONFERENCE. LAS VEGAS, OCT. 7 - 11, 1991, vol. CONF. 22, 7 octobre 1991 (1991-10-07) , pages 118-123, XP010039261, NEW YORK, IEEE, US DOI: 10.1109/PVSC.1991.169193 ISBN: 978-0-87942-636-1
- PARTANEN J ET AL: "Effects of various pre-intrinsic and phosphorus diffusion gettering treatments upon quality of Czochralski silicon wafer surface during a simulated 4 megabit dynamic random access memory process", JOURNAL OF THE ELECTROCHEMICAL SOCIETY, vol. 139, no. 5, mai 1992 (1992-05), pages 1431-1437, XP002659946, USA ISSN: 0013-4651
- PERICHAUD I ET AL: "EFFECT GETTER DANS DES PLAQUETTES DE SILICIUM MULTICRISTALLIN PAR DIFFUSION DE PHOSPHORE", JOURNAL DE PHYSIQUE III, EDITIONS DE PHYSIQUE, PARIS, FR, vol. 2, no. 3, 1 mars 1992 (1992-03-01), pages 313-324, XP000331201, ISSN: 1155-4320, DOI: 10.1051/JP3:1992130
- LOGHMARTI M ET AL: "HIGH PHOSPHORUS GETTERING EFFICIENCY IN POLYCRYSTALLINE SILICON BY OPTIMISATION OF CLASSICAL THERMAL ANNEALING CONDITIONS", PHYSICA STATUS SOLIDI (A). APPLIED RESEARCH, BERLIN, DE, vol. 151, no. 2, 16 octobre 1995 (1995-10-16), pages 379-386, XP008051790, ISSN: 0031-8965
- PERICHAUD I: "Gettering of impurities in solar silicon", SOLAR ENERGY MATERIALS AND SOLAR CELLS, ELSEVIER SCIENCE PUBLISHERS, AMSTERDAM, NL, vol. 72, no. 1-4, 1 avril 2002 (2002-04-01), pages 315-326, XP004339779, ISSN: 0927-0248, DOI: 10.1016/S0927-0248(01)00179-9

## Description

L'invention concerne un procédé de purification d'un substrat en silicium cristallin ainsi qu'un procédé d'élaboration d'une cellule photovoltaïque.

Actuellement, de nombreuses recherches se focalisent sur l'utilisation de substrats en silicium "bas coût", c'est-à-dire des substrats en un silicium qui contient des concentrations élevées en impuretés, notamment métalliques, pour la fabrication de cellules photovoltaïques. Ce silicium bas coût, qui peut être du silicium monocristallin ou du silicium multicristallin, c'est-à-dire du silicium dont les grains ont une taille de 1 mm² à plusieurs cm² et dont la croissance est colonnaire et qui est appelé ci-après d'une manière générale silicium cristallin, contient de façon générale des impuretés métalliques telles que Fe, Cr, Cu..., à des concentrations bien plus élevées que le silicium cristallin de qualité électronique.

Ces impuretés métalliques sont présentes dans le silicium en solution solide et/ou sous la forme de précipités.

Dans le silicium multicristallin, les précipités sont généralement situés le long des défauts cristallographiques étendus (dislocations, joints de grain, macles). Les impuretés métalliques sont des centres de recombinaison virulents pour les charges libres dans le silicium. Ainsi, leur présence affecte la durée de vie des porteurs de charge, et par conséquent le rendement de conversion énergétique des cellules photovoltaïques.

Ainsi, si on veut conserver des rendements de conversion énergétique acceptables en utilisant ces nouvelles sources de silicium cristallin, il faut au cours du procédé de fabrication de la cellule photovoltaïque extraire les impuretés du volume du dispositif, pour limiter au mieux leur influence sur les performances de la cellule photovoltaïque.

A cet effet, une solution proposée dans l'art antérieur est d'extraire ces impuretés par effet getter externe. Ce procédé a pour but de retirer les impuretés métalliques du volume du substrat en silicium pour les confiner aux surfaces de celui-ci où elles ne peuvent plus avoir d'influence sur le fonctionnement des cellules photovoltaïques fabriquées à partir de ce substrat.

L'efficacité de cette extraction des impuretés par effet getter externe est en particulier décrite dans "Mechanisms and computer modelling of transition element gettering in silicon", de Schröter et al, Solar Energy Materials & Solar Cells 72 (2002) 299-313*.*

Un procédé d'extraction des impuretés par effet getter externe particulièrement utilisé est le procédé de diffusion du phosphore qui permet non seulement d'extraire les impuretés métalliques mais également est une étape nécessaire à la formation de la jonction p-n de la cellule photovoltaïque.

Par exemple, R. Douglas et al. ont comparé les effets de PH3 et POCl3 dans "The effects of different diffusion sources on silicon solar cell recombination properties", Twenty First IEEE Photovoltaic Specialists Conference, Kissimimee, Fllorida, 1990, Part 2, pages 311-316.

La diffusion du phosphore est donc très utilisée lors de la fabrication de cellules photovoltaïques. Cependant, si l'extraction des impuretés par effet getter externe et, en particulier, par diffusion du phosphore, permet une extraction efficace des impuretés métalliques initialement en solution solide, notamment lorsque celles-ci diffusent rapidement, par contre, cette étape s'avère peu efficace pour l'extraction des atomes métalliques initialement précipités. Or, ces précipités altèrent les propriétés électriques des défauts cristallographiques étendus et de plus, lors du recuit rapide nécessaire à la prise des contacts métalliques dans le procédé standard de fabrication des cellules photovoltaïques, ces précipités ne sont pas stables et remettent en solution des impuretés métalliques, qui dégradent fortement la durée de vie globale des porteurs de charges et par conséquent les performances des cellules photovoltaïques.

L'invention a pour but de pallier les inconvénients des procédés de l'art antérieur de purification des substrats en silicium cristallin, en particulier pour la fabrication de cellules photovoltaïques.

A cet effet, l'invention propose un procédé de purification d'un substrat en silicium cristallin du type comprenant une étape d'extraction des impuretés par effet getter externe caractérisé en ce qu'il comprend, avant ladite étape d'extraction des impuretés par effet getter externe, au moins une étape de chauffage du substrat à une température comprise entre 750°C et 1000°C inclus pendant une durée comprise entre 1 seconde et 10 minutes inclus, suivie d'une étape de refroidissement du substrat à la température ambiante.

De préférence, l'étape d'extraction des impuretés par effet getter externe est une étape de diffusion du phosphore.

Dans un premier mode de mise en oeuvre préféré, le procédé de purification de l'invention comprend une seule étape de chauffage à une seule température, suivie d'une étape de refroidissement du substrat à la température ambiante.

Dans un second mode de mise en oeuvre préféré, le procédé de purification de l'invention comprend au moins deux étapes de chauffage à des températures différentes pendant des durées identiques ou différentes, suivies d'une étape de refroidissement du substrat à la température ambiante.

Dans ce cas, de préférence, le procédé de purification de l'invention comprend une étape de chauffage entre 800°C et 850°C pendant 1 à 20 secondes et une étape de chauffage à 885°C pendant 1 à 20 secondes, suivies d'une étape de refroidissement du substrat à la température ambiante.

L'invention propose également un procédé d'élaboration d'une cellule photovoltaïque du type comprenant une étape de texturation des surfaces d'un substrat en silicium cristallin, caractérisé en ce qu'il comprend de plus la purification du silicium cristallin constituant le substrat par le procédé de purification de l'invention.

Dans un premier mode de mise en oeuvre préféré du procédé d'élaboration d'une cellule photovoltaïque selon l'invention, la purification du silicium cristallin par le procédé de l'invention est mise en oeuvre avant l'étape de texturation des surfaces du substrat de silicium cristallin.

Dans un second mode de mise en oeuvre préféré du procédé d'élaboration d'une cellule photovoltaïque de l'invention, la purification du silicium cristallin constituant le substrat par le procédé de purification de l'invention est mise en oeuvre après l'étape de texturation des surfaces du substrat de silicium cristallin.

L'invention sera mieux comprise, et d'autre caractéristiques et avantages de celle-ci apparaîtront plus clairement à la lecture de la description explicative qui suit.

Actuellement, le procédé standard utilisé pour la production industrielle de cellules photovoltaïques de type p comprend les étapes séquentielles suivantes :
a) texturation des surfaces d'un substrat en silicium cristallin, en général par traitement avec une solution de KOH, pour diminuer la réflectivité et obtenir un confinement optique,
b) formation d'une couche n+, par diffusion du phosphore pour créer la jonction p-n,
c) dépôt d'une couche de nitrure de silicium hydrogéné SiN-H, par dépôt chimique en phase vapeur assisté par plasma (PECVD) pour créer une couche antireflet, passiver la face avant et servir de réservoir d'hydrogène pour la passivation du volume du substrat,
d) dépôt de contacts par sérigraphie, ces contacts étant en général en argent sur la face avant et en aluminium sur la face arrière,
e) recuit des contacts, dans un four à lampes infrarouges pour la prise des contacts sur le silicium.
   Par les termes « texturation d'une (ou des) surface(s) d'un substrat » ou le terme « texturation », on entend dans l'invention, la création d'une succession de creux et de reliefs sur cette surface.
   Le contact Al-Si sur la face arrière piège les impuretés et on a création d'une zone p+ qui joue le rôle de BSF ("Back Surface Field"), c'est-à-dire le rôle de champ électrique repoussant les porteurs minoritaires en face arrière de la cellule. Lors de cette étape, l'hydrogène migre depuis la couche de SiN-H ce qui passive les impuretés dans le volume du substrat, et
f) ouverture de la jonction, par exemple par laser, ou par plasma ou encore par enrobage ou par tout autre moyen de gravure.

Sans rien changer à ce procédé, on peut également obtenir des cellules photovoltaïques de type n. Dans ce cas, la zone p+ dopée à l'aluminium sur la face arrière de la cellule permet la création de la jonction n-p+. La zone n+ obtenue par la diffusion du phosphore sur la face avant joue le rôle de repoussoir des trous (effet FSF, "Front Surface Field").
L'étape b) de formation de la couche n+ par diffusion du phosphore est non seulement nécessaire pour la formation de la jonction p-n, mais également développe un effet getter externe permettant d'extraire les impuretés métalliques.

La diffusion du phosphore peut être réalisée, par exemple, par un flux de POCl₃, PBr₃, PH₃ ou P₂O₅. Cette diffusion est réalisée en 2 étapes. La première étape consiste à créer un oxyde fortement dopé en phosphore à la surface du silicium sous une température comprise entre 800°C et 900°C (entre 10mn et 30mn) sous flux d'oxygène et d'azote ayant barboté dans un récipient contenant, de préférence, du POCl₃ sous forme liquide. La seconde étape consiste à faire diffuser le phosphore de l'oxyde vers le silicium sous une température comprise entre 800°C et 900°C (entre 30s et 10mn). Elle peut également être réalisée par "spin-on" ou par spray. La technique de "spin-on" (à la tournette) consiste à déposer à la surface des plaquettes une solution dopante par centrifugation. Le dépôt est suivi d'un recuit vers 170°C permettant l'évaporation des solvants. L'étape de diffusion peut se faire dans un four à tube conventionnel ou dans un four à passage.

Lors de la diffusion du phosphore, les impuretés sont extraites des précipités ou des sites substitutionnels, et une diffusion rapide de ces impuretés en position interstitielle vers les sites ou les zones de piégeage situées sur toutes les surfaces de la cellule se produit. Ensuite, les impuretés sont capturées dans ces sites ou ces zones de piégeage. Cette étape est cruciale car elle doit permettre de fixer les impuretés qui parviennent aux sites ou aux zones de piégeage par deux mécanismes différents : tout d'abord, la relaxation des impuretés (précipitation) en sursaturation, et d'autre part, la ségrégation des impuretés par suite d'une variation voulue de leur solubilité limite à travers le cristal.

De plus, si la diffusion du phosphore permet une extraction efficace des impuretés métalliques initialement en solution solide, notamment lorsque celles-ci diffusent rapidement, cette étape s'avère peu efficace pour l'extraction des atomes métalliques initialement précipités. Or, ces précipités altèrent les propriétés électriques des défauts cristallographiques étendus. De plus, dans le procédé de fabrication d'une cellule photovoltaïque actuellement utilisée, l'étape b) de diffusion du phosphore est suivie par l'étape e) de recuit des contacts déposés par sérigraphie. Cette étape s'effectue à des températures de l'ordre de 800°C à 900°C et, au cours de cette étape, il se produit une remise en solution des impuretés métalliques initialement précipitées. Ces impuretés métalliques remises en solution dégradent fortement la durée de vie globale des porteurs de charge et par conséquent les performances des cellules photovoltaïques.

Or, on a maintenant découvert que si l'on procédait à un recuit rapide à haute température du substrat en silicium cristallin utilisé lors de l'élaboration des cellules photovoltaïques avant la diffusion du phosphore, les impuretés métalliques initialement précipitées sont mises en solution, ce qui permettra à l'étape d'extraction des impuretés métalliques par effet getter externe de les extraire efficacement et durablement. Les défauts cristallographiques étendus, où précipitent facilement les impuretés métalliques seront alors moins recombinants et de plus, le matériau sera électriquement plus stable au cours du procédé permettant la fabrication du dispositif, notamment au cours d'éventuels recuits rapides.

L'étape de recuit rapide est, comme cela est connu de l'homme du métier du traitement des substrats en silicium, une étape au cours de laquelle le substrat en silicium est porté très rapidement, c'est-à-dire en quelques secondes à quelques minutes, à une température élevée de jusqu'à 1200°C au plus, puis refroidi lentement pour éviter sa rupture par choc thermique.

Cette étape de recuit rapide appelée également ici "pré-gettering externe" se fait en général via des fours à lampes, statiques ou dynamiques. Ce recuit rapide peut être réalisé sous air ou sous atmosphère non oxydante tel qu'un flux d'argon, d'hélium, etc...

Dans l'invention, à l'étape de recuit rapide, la température à laquelle le substrat de silicium est porté doit se situer entre 750°C et 1000°C, et ce pendant des durées comprises entre 1 seconde à 10 minutes inclus.

De préférence, cette température est comprise entre 800°C et 950°inclus. Le recuit rapide peut être constitué d'un unique palier à la température voulue ou d'une succession de paliers à différentes températures, suivi(s) d'un refroidissement à température ambiante. De préférence, l'étape de recuit rapide est constituée de deux paliers successifs, le premier palier étant effectué à une température comprise entre 800°C et 850°C pendant 1 à 20 secondes, et le deuxième palier à une température comprise entre 850°C et 920°C pendant 1 à 20 secondes.

Quant à l'étape de refroidissement de cette étape de recuit rapide, elle s'effectue par refroidissement naturel après avoir éteint la source de chauffage ou encore par un refroidissement forcé, par exemple par passage sur le substrat d'un flux d'air à température ambiante.

Lorsque le refroidissement est un refroidissement forcé, la vitesse de refroidissement du substrat doit être de préférence supérieure à 3°C / seconde.

Afin de mieux faire comprendre l'invention, on va maintenant décrire à titre d'exemples purement illustratifs et non limitatifs plusieurs modes de mise en oeuvre.

### Préparation des plaquettes de silicium

On a découpé, dans un même lingot de silicium multicristallin dopé au bore issu du procédé de cristallisation Polix ^{®}, deux plaquettes de silicium. Ce lingot de silicium a une résistivité comprise entre 0,5 et 2 ohm.cm. Les plaquettes sont carrées et ont une surface de 225 cm². La taille des grains varie entre quelques mm² et quelques cm².

### Exemple comparatif

Sur une des plaquettes obtenues ci-dessus, on a mis en oeuvre un simple traitement de diffusion du phosphore. Ce traitement de diffusion du phosphore était le suivant : une plaquette est plaquée verticalement dans des nacelles en quartz qui sont elles-mêmes installées dans un four à tube également en quartz. La température du four est contrôlée à 870°C et une faible pression (de 300 Mbar) est maintenue dans le tube.

Un flux porteur de N₂ chargé en POCl₃ est injecté à cette température et pression pendant 18 minutes. Du verre de phosphore P₂O₅ se dépose sur les plaquettes.

A partir de ce verre de phosphore, les atomes de phosphore diffusent à travers la matrice de silicium. La profondeur de jonction dépend de la température et de la durée du cycle.

La réaction chimique qui se produit est la suivante :

6POCl₃ + 3O₂ → 2P₂O₅ + 6Cl₂.

Après cette étape de diffusion du phosphore, la couche diffusée n+ est décapée par attaque chimique (mélange HF - CH3COOH - HNO3), attaque qui permet également un polissage chimique des surfaces. Les surfaces sont ensuite passivées électriquement par le dépôt PECVD d'une couche de nitrure de silicium. La durée de vie volumique est alors mesurée par µWave-PCD (Photoconductive Decay) comme décrit dans Stevenson et al., Appl. Phys. Lett. 26, 190 (1955) ou par la technique IC-QssPC (Inductively-Coupled Quasi-Steady-State Photoconductive Decay), comme décrit dans Sinton et al., Appl. Phys. Lett. 69, 2510 (1996).

La valeur de la durée de vie de cette plaquette de silicium n'ayant subi qu'un traitement de diffusion du phosphore est de 125 µs.

### Exemple selon l'invention

La deuxième plaquette de silicium préparée a été soumise au même traitement que la plaquette de l'exemple comparatif ci-dessus sauf que l'étape de diffusion du phosphore avait été précédée d'une étape de recuit rapide, c'est à dire à un traitement thermique à deux paliers :
- un premier palier à 830°C pendant 15 secondes, et
- un second palier à 885°C pendant 15 secondes.

Les vitesses de montée en température à 830°C et 885°C étaient de 30°C / seconde.

Le chauffage était effectué dans un four à lampe.

Pour l'étape de refroidissement, le four à lampe a été éteint et la plaquette de silicium a été soumise à un refroidissement forcé à l'aide de ventilateurs.

L'étape de recuit rapide a été effectuée sous air.

La plaquette a ensuite été soumise à une étape d'extraction d'impuretés de façon standard, par diffusion de phosphore.

La valeur de la durée de vie de cette plaquette de silicium purifiée par le procédé de l'invention est de 156 µs. Cette valeur est légèrement supérieure à celle de la plaquette n'ayant subi qu'une étape de diffusion du phosphore.

Cela montre que les impuretés métalliques mises en solution pendant l'étape de recuit rapide ont été extraites lors de l'étape de diffusion du phosphore.

La densité d'impuretés métalliques précipitées dans les plaquettes traitées par le procédé de purification de l'invention est donc inférieure à la densité d'impuretés métalliques précipitées sur des plaquettes auxquelles seule une étape de diffusion du phosphore a été appliquée.

Dès lors, les propriétés électriques des substrats ayant subi le procédé de purification de l'invention sont moins sensibles au recuit rapide qui suit l'étape de sérigraphie pour la prise des contacts métalliques.

Bien que dans la description qui précède, l'extraction des impuretés par effet getter externe ait été décrite comme étant une étape de diffusion du phosphore, diverses techniques développent un effet getter externe des impuretés, telles que l'effet getter par endommagement, par dépôt de polysilicium, par formation d'une couche poreuse ou encore par un substrat fortement dopé (couches épitaxiées) ou encore par la formation de nano-cavités ou par un alliage aluminium-silicium peuvent également être utilisées. Toutes ces techniques sont utilisables dans les procédés de l'invention.

## Revendications

1. Procédé de purification d'un substrat en silicium cristallin du type comprenant une étape d'extraction des impuretés par effet getter externe **caractérisé en ce qu'**il comprend, avant ladite étape d'extraction des impuretés par effet getter externe, au moins une étape de chauffage du substrat à une température comprise entre 750°C et 1000°C inclus pendant une durée comprise entre 1 seconde et 10 minutes inclus, suivie d'une étape de refroidissement du substrat à la température ambiante.

2. Procédé de purification d'un substrat en silicium cristallin selon la revendication 1 **caractérisé en ce que** l'étape d'extraction des impuretés par effet getter externe est une étape de diffusion du phosphore.

3. Procédé selon la revendication 1 ou 2 **caractérisé en ce qu'**il comprend une seule étape de chauffage à une seule température, suivie d'une étape de refroidissement du substrat à la température ambiante.

4. Procédé selon la revendication 1 ou 2 **caractérisé en ce qu'**il comprend au moins deux étapes de chauffage à des températures différentes pendant des durées identiques ou différentes, suivies d'une étape de refroidissement du substrat à la température ambiante.

5. Procédé selon l'une quelconque des revendications 1 ou 2 ou 4 **caractérisé en ce qu'**il comprend une étape de chauffage entre 800°C et 850°C pendant 1 à 20 secondes et une étape de chauffage entre 850°C et 920°C pendant 1 à 20 secondes, suivies d'une étape de refroidissement du substrat à la température ambiante.

6. Procédé d'élaboration d'une cellule photovoltaïque du type comprenant une étape de texturation des surfaces d'un substrat en silicium cristallin, **caractérisé en ce qu'**il comprend de plus la purification du silicium cristallin constituant le substrat par le procédé selon l'une quelconque des revendications 1 à 5.

7. Procédé selon la revendication 6 **caractérisé en ce que** la purification du silicium cristallin par le procédé selon l'une quelconque des revendications 1 à 5 est mise en oeuvre avant l'étape de texturation des surfaces du substrat de silicium cristallin.

8. Procédé d'élaboration d'une cellule photovoltaïque en silicium cristallin selon la revendication 6 **caractérisé en ce que** la purification du silicium cristallin par le procédé selon l'une quelconque des revendications 1 à 5 est mise en oeuvre après l'étape de texturation des surfaces du substrat de silicium cristallin.

9. Procédé de purification d'un substrat en silicium selon l'une quelconque des revendications 1 à 5, **caractérisé en ce que** l'étape de refroidissement du substrat à la température ambiante est une étape de refroidissement naturel après avoir éteint la source de chauffage ou une étape de refroidissement forcé à une vitesse de refroidissement supérieure à 3°C/secondes.

## Patentansprüche

1. Verfahren zur Aufreinigung eines Substrats aus kristallinem Silicium von dem Typ, der einen Schritt der Extraktion von Verunreinigungen durch einen externen Gettereffekt umfasst, **dadurch gekennzeichnet, dass** es vor dem besagten Schritt der Extraktion von Verunreinigungen durch einen externen Gettereffekt mindestens einen Schritt der Erhitzung des Substrats auf eine Temperatur zwischen 750 °C und 1000 °C einschließlich für eine Dauer zwischen 1 Sekunde und 10 Minuten einschließlich, gefolgt von einem Schritt der Abkühlung des Substrats auf Umgebungstemperatur umfasst.

2. Verfahren zur Aufreinigung eines Substrats aus kristallinem Silicium nach Anspruch 1, **dadurch gekennzeichnet, dass** der Schritt der Extraktion von Verunreinigungen durch einen externen Gettereffekt ein Phosphordiffusionsschritt ist.

3. Verfahren nach Anspruch 1 oder 2, **dadurch gekennzeichnet, dass** es einen einzigen Schritt der Erhitzung auf eine einzige Temperatur, gefolgt von einem Schritt der Abkühlung des Substrats auf Umgebungstemperatur umfasst.

4. Verfahren nach Anspruch 1 oder 2, **dadurch gekennzeichnet, dass** es mindestens zwei Schritte der Erhitzung auf unterschiedliche Temperaturen für gleiche oder verschiedene Dauern, gefolgt von einem Schritt der Abkühlung des Substrats auf Umgebungstemperatur umfasst.

5. Verfahren nach einem der Ansprüche 1 oder 2 oder 4, **dadurch gekennzeichnet, dass** es einen Schritt der Erhitzung auf zwischen 800 °C und 850 °C für 1 bis 20 Sekunden und einen Schritt der Erhitzung auf zwischen 850 °C und 920 °C für 1 bis 20 Sekunden, gefolgt von einem Schritt der Abkühlung des Substrats auf Umgebungstemperatur umfasst.

6. Verfahren zur Herstellung einer Solarzelle von dem Typ, der einen Schritt der Texturierung von Oberflächen eines Substrats aus kristallinem Silicium umfasst, **dadurch gekennzeichnet, dass** es außerdem die Aufreinigung des kristallinen Siliciums, das das Substrat bildet, durch das Verfahren nach einem der Ansprüche 1 bis 5 umfasst.

7. Verfahren nach Anspruch 6, **dadurch gekennzeichnet, dass** die Aufreinigung des kristallinen Siliciums durch das Verfahren nach einem der Ansprüche 1 bis 5 vor dem Schritt der Texturierung von Oberflächen des Substrats aus kristallinem Silicium durchgeführt wird.

8. Verfahren zur Herstellung einer Solarzelle aus kristallinem Silicium nach Anspruch 6, **dadurch gekennzeichnet, dass** die Aufreinigung des kristallinen Siliciums durch das Verfahren nach einem der Ansprüche 1 bis 5 nach dem Schritt der Texturierung von Oberflächen des Substrats aus kristallinem Silicium durchgeführt wird.

9. Verfahren zur Aufreinigung eines Substrats aus Silicium nach einem der Ansprüche 1 bis 5, **dadurch gekennzeichnet, dass** der Schritt der Abkühlung des Substrats auf Umgebungstemperatur ein natürlicher Abkühlungsschritt, nachdem die Heizquelle abgeschaltet wurde, oder ein Zwangsabkühlungsschritt mit einer Abkühlgeschwindigkeit von mehr als 3 °C/Sekunde ist.

## Claims

1. Method for purification of a crystalline silicon substrate of the type including a step to extract impurities by external getter effect, **characterised in that** before said step to extract impurities by external getter effect, it comprises at least one heating step of the substrate to a temperature of between 750°C and 1000°C inclusive for a period of between 1 second and 10 minutes inclusive, followed by a cooling step of the substrate to ambient temperature.

2. Method for purification of a crystalline silicon substrate according to claim 1, **characterised in that** the step to extract impurities by external getter effect is a phosphorus diffusion step.

3. Method according to claim 1 or 2, **characterised in that** it comprises only one heating step to only one temperature, followed by a cooling step of the substrate to ambient temperature.

4. Method according to claim 1 or 2, **characterised in that** it comprises at least two heating steps to different temperatures during identical or different periods, both followed by a cooling step of the substrate to ambient temperature.

5. Method according to any one of claims 1, 2 or 4, **characterised in that** it comprises a heating step to between 800°C and 850°C for 1 to 20 seconds and a heating step to between 850°C and 920°C for 1 to 20 seconds, both followed by a cooling step of the substrate to ambient temperature.

6. Method of manufacturing a photovoltaic cell of the type including a texturing step of the surfaces of a crystalline silicon substrate, **characterised in that** it furthermore comprises a purification of the crystalline silicon forming the substrate by the method according to any one of claims 1 to 5.

7. Method according to claim 6, **characterised in** the purification of the crystalline silicon by the method according to any one of claims 1 to 5 is carried out before the texturing step of the surfaces of crystalline silicon substrate.

8. Method of manufacturing a crystalline silicon photovoltaic cell according to claim 6, **characterised in that** the purification of the crystalline silicon by the method according to any one of claims 1 to 5 is carried out after the texturing step of the surfaces of crystalline silicon substrate.

9. Method of purification of a silicon substrate according to any one of claims 1 to 5, **characterised in that** the cooling step of the substrate to ambient temperature is a natural cooling step after the heating source has been cut off or a forced cooling step at a cooling rate higher than 3°C/second.
